# EUROPÄISCHE PATENTSCHRIFT

(11) **EP 1 137 107 B1**
(45) Veröffentlichungstag und Bekanntmachung des Hinweises auf die Patenterteilung: **17.12.2003**
(21) Anmeldenummer: 01106283.3
(22) Anmeldetag: 15.03.2001
(51) Int. Cl.: H01R 12/04

(54) **Andruckverbinder**
Abutting connector
Connecteur à pression

(30) Priorität: 24.03.2000 DE 10014338
(43) Veröffentlichungstag der Anmeldung: 26.09.2001
(73) Patentinhaber: W.C. Heraeus GmbH & Co. KG, 63450 Hanau (DE)
(72) Erfinder: Gehlert, Bernd, 63486 Bruchköbel (DE)
(74) Vertreter: Kühn, Hans-Christian

(56) Entgegenhaltungen:
- FR-A- 2 712 454
- US-A- 5 139 427
- US-A- 6 022 224

## Beschreibung

Die Erfindung betrifft einen Andruckverbinder zum Kontaktieren von unterschiedlichen Leiterbahnebenen von Leiterrahmen/-platten.

Aus dem Stand der Technik ist eine Vielzahl von elektrischen Verbindem bekannt, die ein buchsenartiges Gehäuseelement und ein steckartiges Gehäuseelement aufweisen. Beispielsweise ist aus DE 195 41 805 A1 ein solcher elektrischer Verbinder bekannt, bei dem jedes Gehäuseelement Einrichtungen zur Aufnahme eines Verriegelungsschlüssels besitzt, der zwei Stellungen einnehmen kann, eine Bereitschaftsstellung, in der er das Instellungbringen der Kontaktorgane ermöglicht, und eine Verriegelungsstellung, in der die Verriegelungsschlüssel die Kontaktorgane verriegeln. Jeder Verriegelungsschlüssel weist Mittel auf, die einem Einsetzen des steckerartigen Gehäuseelementes in das buchsenartige Gehäuseelement entgegenwirken, wenn sich der jeweilige Schlüssel in der Bereitschaftsstellung befindet.

In US 5,297,967 A, FR 2 784 806 A1, US 5 139 427 A und US 5, 152,695 A sind Andruckverbinder offenbart, deren erste und zweite Kontaktelemente über Andruck- und Verbindungselemente und über Biegelinien gelenkig miteinander verbunden sind, wobei die Elemente im nicht-kontaktierten Zustand nahezu in einer Ebene anordbar sind.

Nachteilig bei zwischen zwei Leiterrahmen/-platten zur elektrischen Kontaktierung angeordneten Andruckverbindern mit Spiralfedern ist insbesondere, dass für unterschiedliche Abstände der Leiterrahmen/-platten entsprechend dimensionierte Andruckverbinder bereitgestellt werden müssen, um auf der einen Seite einen sicheren elektrischen Kontakt zu gewährleisten und auf der anderen Seite keine allzu hohen Kräfte auf die einzelnen Leiterrahmen/-platten auszuüben, um eventuelle Beschädigungen zu vermeiden. Darüber hinaus wird lediglich nur ein Werkstoff insbesondere federharte Edelmetallmassivdrähte und Manteldrähte für die Kontaktierung verwendet, was zu einer grossen Materialabhängigkeit bezüglich der Kontaktsicherheit führt.

Aus dem vorgenannten ergibt sich somit das Problem, einen Andruckverbinder bereitzustellen, der die oben genannten Nachteile zumindest teilweise vermeidet. Das der Erfindung zugrundeliegende Problem liegt insbesondere darin, einen Andruckverbinder bereitzustellen, der problemlos für verschiedene Leiterrahmen/-platten-Abstände eingesetzt werden kann.

Dieses Problem wird erfindungsgemäß durch einen Andruckverbinder nach Anspruch 1 gelöst.

Der erfindungsgemäße Andruckverbinder zum Kontaktieren von unterschiedlichen Leiterbahnebenen von Leiterrahmen/-platten weist mindestens ein Kontaktelement für eine erste Leiterbahnebene und mindestens ein zweites Kontaktelement für eine zweite Leiterbahnebene auf. Dabei ist das erste Kontaktelement über Andruck- und Verbindungselemente mit dem zweiten Kontaktelement verbunden. Die Kontaktelemente sind mit den Andruckelementen über Biegelinien gelenkig miteinander verbunden. Weiterhin sind die Andruckelemente mit den Verbindungselementen über Biegelinien gelenkig miteinander verbunden. Beides ist derart ausgestaltet, dass die Elemente im nicht-kontaktierenden Zustand in einer Ebene anordbar sind. Dies geschieht insbesondere durch eine Zugbewegung der sich gegenüberliegenden Enden in entgegengesetzte Richtungen, wobei sämtliche Kontakt- und Andruckelemente ohne friktionsbehaftete Relativbewegungen zwischen Andruckverbinder und Leiterbahnen in eine Ebene verschwenken.

Der erfindungsgemäße Andruckverbinder kann aus konventionellen Materialien beispielsweise aus einer CuBe2-Legierung bestehen.

Zur Bereitstellung einer Kontaktredundanz weist der Andruckverbinder zwei zweite Kontaktelemente auf.

Die Kontaktelemente sind streifenförmig und/oder linienförmig, da bei einer streifenförmigen Ausführung eine große Kontaktfläche für einen sicheren Kontakt mit einem Leiterrahmen oder einer Leiterplatte zur Verfügung steht und auf der anderen Seite bei einer linienförmigen Ausgestaltung ein hoher Anpressdruck bereitgestellt werden kann.

Die Andruckelemente und/oder die Verbindungselemente sind streifenförmig, da sich diese Ausführungsform in der Praxis bewährt hat.

Schließlich ist der Andruckverbinder bezüglich einer von einer in Bewegungsrichtung der Kontaktelemente ausgerichteten Achse (X) und einer orthogonal zur Achse (X) ausgerichteten Achse (Y) aufgespannten Ebene und/oder einer von der Achse (X) und einer orthogonal zur Achse (X) und zur Achse (Y) ausgerichteten Achse (Z) aufgespannten Ebene spiegelsymmetrisch aufgebaut, da bei Biegebeanspruchung der federnden Elemente des Andruckverbinders hinsichtlich der Baugruppen auf den einzelnen Leiterrahmen/-platten keine Drehmomente ausgeübt werden und somit eine hohe Kontaktsicherheit bei gleichzeitig geringer mechanischer Beanspruchung der zu kontaktierenden Leiterrahmen/-platten gewährleistet ist.

Der erfindungsgemäße Andruckverbinder kann insbesondere mit seinem ersten Kontaktelement an einen Leiterrahmen geklebt oder gelötet werden. Es besteht die Möglichkeit, dass die zwei zweiten Andruckelemente, die zur Kontaktierung eines zweiten Leiterrahmens dienen, neben dieser originären Funktion zusätzlich als Kurzschlussbrücke benachbarter Leiterbahnen innerhalb einer Leiterbahnebene fungieren können.

Durch eine unterschiedliche Applizierung der entsprechenden Biegelinien kann der Andruckverbinder den jeweiligen Einsatzbedingungen angepasst werden. Die Biegelinien werden in der Regel geprägt und stellen linienförmige Materialbiegungen zur Bereitstellung einer gelenkigen Federwirkung dar.

In Kombination mit Leisten, insbesondere Kunststoffleisten, sind Lösungen für Reihen-Andruckverbinder denkbar. Diese können beispielsweise darin bestehen, dass die erfindungsgemäßen Andruckverbinder zusätzlich - über den eigentlichen Grundkörper hinaus - Rastnasen zur gleichzeitigen Montage auf Leiterplatten aufweisen.

In vorteilhafter Art und Weise weist das erste Kontaktelement und/oder die zweiten Kontaktelemente Kalotten auf, da auf die Kalotten bei kleiner jedoch definierter Kontaktauflagefläche ein relativ hoher Kontaktdruck im kontaktierenden Zustand wirkt.

Zur leichten Montage des Andruckverbinders an Leiterplatten weist das Verbindungselement vorteilhafterweise Einpress-Stifte auf.

Die nachfolgenden Beispiele dienen zur Erläuterung der Erfindung:

Es zeigen:
- Figur 1 -: eine perspektivische Darstellung eines Andruckverbinders in kontaktierendem Zustand;
- Figur 2 -: eine skizzenhafte Aufsicht einer ersten Ausführungsform eines erfindungsgemäßen Andruckverbinders;
- Figur 3 -: eine skizzenhafte Aufsicht einer zweiten Ausführungsform des erfindungsgemäßen Andruckverbinders;
- Figur 4 -: eine skizzenhafte Aufsicht einer dritten Ausführungsform des erfindungsgemäßen Andruckverbinders;
- Figur 5 -: eine skizzenhafte Aufsicht mehrerer paralleler Andruckverbinder gemäß der in Figur 4 gezeigten Ausführungsform.

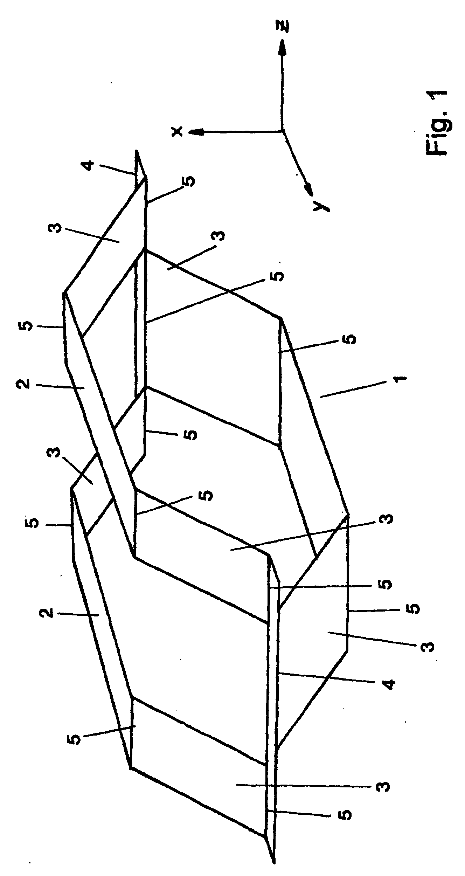

In Figur 1 ist eine perspektivische Darstellung einer möglichen Ausführungsform des erfindungsgemäßen Andruckverbinders dargestellt.

Der Andruckverbinder weist ein unteres erstes streifenförmiges Kontaktelement 1 sowie zwei obere zweite streifenförmige Kontaktelemente 2 auf. Die Kontaktelemente 1 und 2 sind über streifenförmige Andruckelemente 3 und streifenförmige Verbindungselemente 4 mittels eingeprägter Biegelinien 5 gelenkig miteinander verbunden, so dass durch Zusammendrücken und Auseinanderziehen der Verbindungselemente 4 zueinander die Höhendifferenz zwischen dem ersten Kontaktelement 1 und den beiden zweiten Kontaktelementen 2 variabel einstellbar ist.

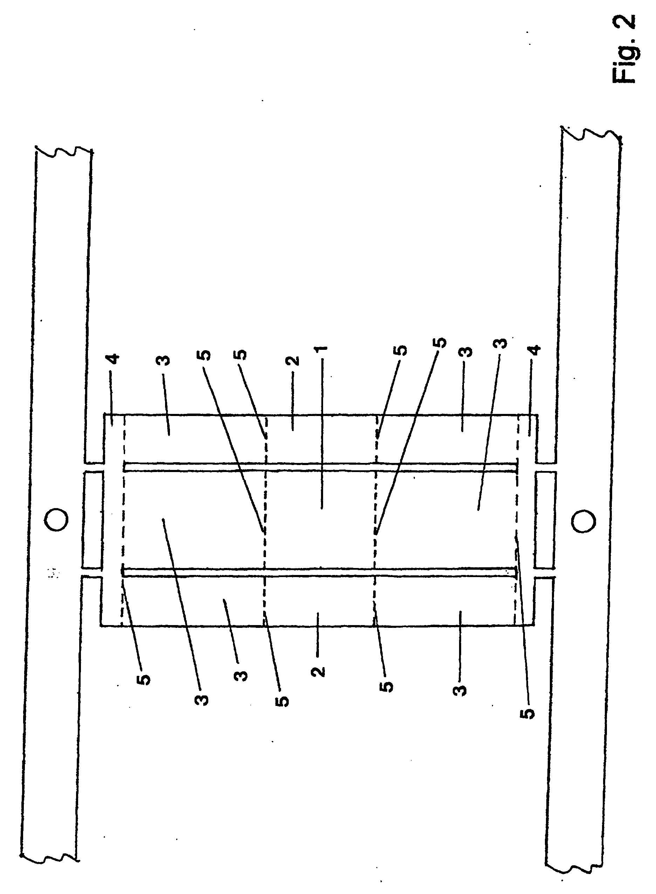

In Figur 2 ist eine skizzenhafte Aufsicht der in Figur 1 gezeigten Ausführungsform des erfindungsgemäßen Andruckverbinders dargestellt.

Auch hier sind insbesondere die Kontaktelemente 1 und 2 zu erkennen, wobei aus der Aufsicht klar zu erkennen ist, dass bei einem entsprechenden Umbiegen der Elemente die zunächst untere erste Kontaktfläche 1 zur oberen Kontaktfläche 1 und die zunächst oberen zweiten Kontaktflächen 2 in untere Kontaktflächen umgewandelt werden können. Weiterhin ist zu erkennen, dass die Verbindungselemente 4 jeweils über zwei kleine Stege an produktionsbedingten Führungsstreifen befestigt sind.

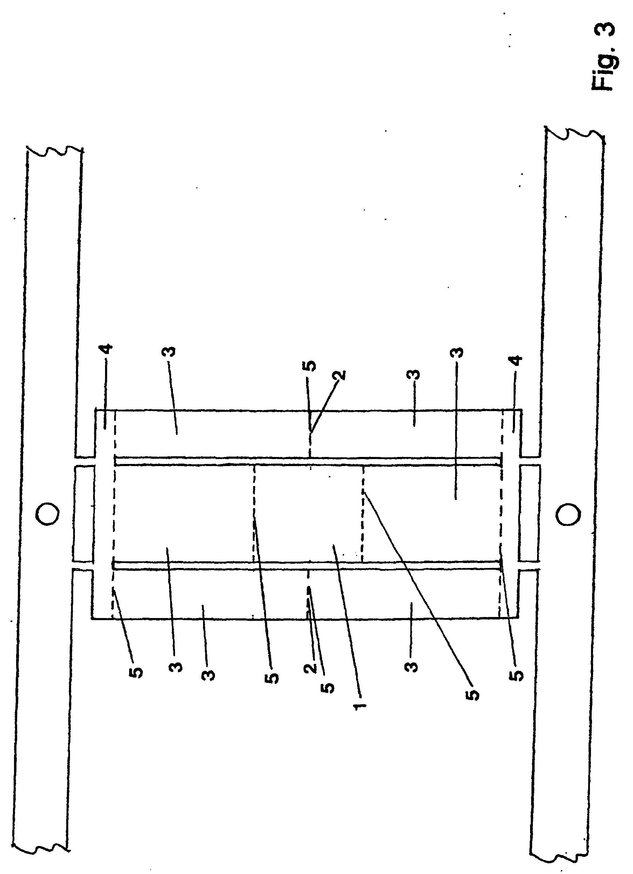

In Figur 3 ist eine weitere Ausführungsform des erfindungsgemäßen Andruckverbinders skizziert. Im Unterschied zu der in den Figuren 1 und 2 aufgezeigten ersten Ausführungsform weist diese nunmehr lediglich linienförmige zweite Kontaktelemente 2 auf, die gleichzeitig Biegelinien 5 darstellen. Das erste Kontaktelement 1 ist auch hier als Fläche ausgeführt.

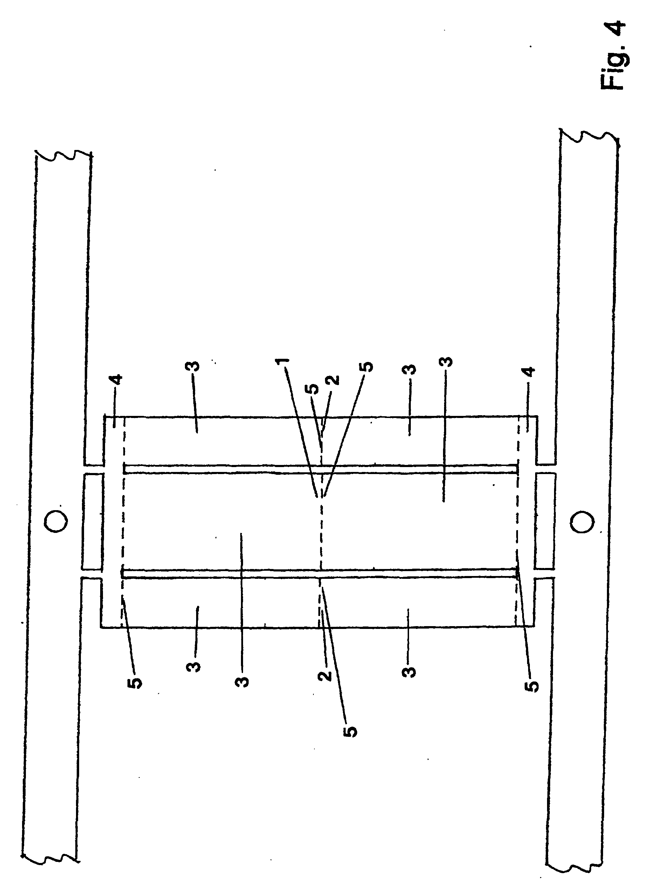

In Figur 4 ist eine weitere Ausführungsform des erfindungsgemäßen Andruckverbinders dargestellt, wobei in diesem Fall sowohl das erste Kontaktelement 1 als auch die beiden zweiten Kontaktelemente 2 linienförmig ausgestaltet sind und auch hier gleichzeitig Biegelinien 5 darstellen.

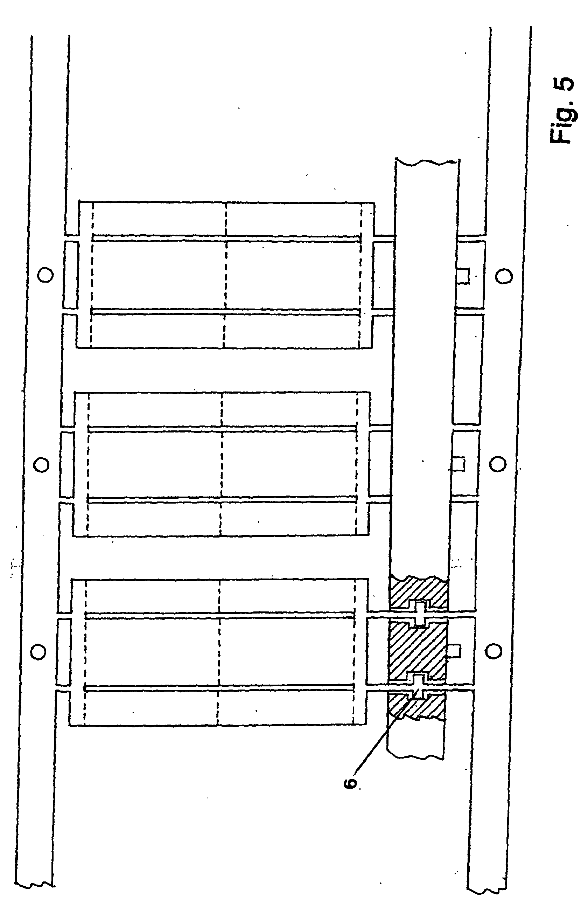

Schließlich ist in Figur 5 die in Figur 4 dargestellte Ausführungsform des erfindungsgemäßen Andruckverbinders dargestellt, wobei mehrere solcher Andruckverbinder parallel über Rastnasen 6 in einer Kunststoffleiste zur gleichzeitigen Montage auf Leiterplatten parallel zueinander angeordnet sind.

## Patentansprüche

1. Andruckverbinder zum Kontaktieren von unterschiedlichen Leiterbahnebenen von Leiterrahmen/-platten, mit:
- mindestens einem ersten Kontaktelement (1) für eine erste Leiterbahnebene und mindestens einem zweiten Kontaktelement (2) für eine zweite Leiterbahnebene,
- wobei das erste Kontaktelement (1) über Andruck- (3) und Verbindungselemente (4) mit dem zweiten Kontaktelement (2) verbunden ist und
- sowohl die Kontakt- (1, 2) mit den Andruckelementen (3) als auch die Andruck- (3) mit den Verbindungselementen (4) derart über Biegelinien (5) gelenkig miteinander verbunden sind, dass die Elemente (1, 2, 3, 4) im nicht-kontaktierenden Zustand in einer Ebene anordbar sind, wobei der Andruckverbinder zwei zweite Kontaktelemente (2) aufweist, **dadurch gekennzeichnet, dass** die Kontaktelemente (1, 2) streifenförmig und/oder linienförmig sind, die Andruckelemente (3) streifenförmig sind, die Verbindungselemente (4) streifenförmig sind und der Andruckverbinder bezüglich einer von einer in Bewegungsrichtung der Kontaktelemente (1, 2) ausgerichteten Achse (X) und einer orthogonal zur Achse (X) ausgerichteten Achse (Y) aufgespannten Ebene und/oder einer von der Achse (X) und einer orthogonal zur Achse (X) und zur Achse (Y) ausgerichteten Achse (Z) ausgespannten Ebene spiegelsymmetrisch aufgebaut ist.

2. Andruckverbinder nach Anspruch 1, **dadurch gekennzeichnet, dass** das erste Kontaktelement (1) und/oder die zweiten Kontaktelemente (2) Kalotten aufweisen.

3. Andruckverbinder nach einem der Ansprüche 1 bis 2, **dadurch gekennzeichnet, dass** das Verbindungselement (4) Einpreß-Stifte für die Leiterplattenmontage aufweist.

## Claims

1. Pressure connector for bonding different conductor track planes of circuit frames/boards, with:
at least one first contact element (1) for a first conductor track plane and at least one second contact element (2) for a second conductor track plane,
wherein the first contact element (1) is connected to the second contact element (2) by pressure elements (3) and connecting elements (4) and
the contact elements (1, 2) are connected to the pressure elements (3), and the pressure elements (3) to the connecting elements (4), in articulated fashion by bend lines (5) so that the elements (1, 2, 3, 4) can be arranged in one plane in the noncontacting condition, the pressure connector having two second contact elements (2), **characterized in that** the contact elements (1, 2) are in strip and/or line form, the pressure elements (3) are in strip form, the connecting elements (4) are in strip form and the pressure connector is constructed mirror-symmetrically with respect to a plane containing an axis (X) orientated in the direction of motion of the contact elements (1, 2) and an axis (Y) orientated at right angles to the axis (X) and/or a to a plane containing the axis (X) and an axis (Z) orientated at right angles to the axis (X) and to the axis (Y).

2. Pressure connector according to Claim 1, **characterized in that** the first contact element (1) and/or the second contact elements (2) have dome-shaped contact pips.

3. Pressure connector according to Claim 1 or Claim 2, **characterized in that** the connecting element (4) has press studs for circuit board assembly.

## Revendications

1. Connecteur par pression en vue de la mise en contact de différents plans de pistes conductrices de panneaux/plaquettes de circuit imprimé, comportant:
- au moins un premier élément de contact (1) pour un premier plan de piste conductrice et au moins un second élément de contact (2) pour un second plan de piste conductrice,
- le premier élément de contact (1) étant relié au second élément de contact (2) par des éléments de pression (3) et de liaison (4)et
- non seulement les éléments de contact (1,2) avec les éléments de pression (3), mais également les éléments de pression (3) avec les éléments de liaison (4) sont réunis de façon articulée par l'intermédiaire de lignes de flexion (5), de sorte que les éléments (1,2,3,4) peuvent être disposés dans un état sans contact dans un plan, le connecteur par pression présentant deux seconds éléments de contact (3), **caractérisé en ce que** les éléments de contact (1,2) sont sous forme de bandes et/ou de lignes, les éléments de pression (3) sont sous forme de bandes, les éléments de liaison (4) sont sous forme de bandes et le connecteur par pression est structuré à symétrie de miroir par rapport à un axe (X) aligné dans la direction de déplacement des éléments de contact (1,2) et par rapport à un plan défini par l'axe (Y) orthogonal à l'axe (X) et/ou par rapport à un plan défini par un axe (Z)) orthogonal à l'axe (X) et aligné sur l'axe (Y).

2. Connecteur par pression selon la revendication 1, **caractérisé en ce que** le premier élément de contact (1) et/ou les seconds éléments de contact(2)présentent des calottes.

3. Connecteur par pression selon une des revendications 1 ou 2, **caractérisé en ce que** l'élément de liaison (4) présente des tiges d'insertion pour le montage des plaquettes de circuit imprimé.
